(19) Europäisches Patentamt / European Patent Office / Office européen des brevets

(11) **EP 2 434 521 A2**

(12) **EUROPEAN PATENT APPLICATION**

(43) Date of publication:
**28.03.2012 Bulletin 2012/13**

(51) Int Cl.:
*H01J 37/285* (2006.01)　　*G01Q 80/00* (2010.01)
*B82Y 35/00* (2011.01)

(21) Application number: **11181316.8**

(22) Date of filing: **15.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.09.2010 US 385813 P**

(71) Applicant: **IMEC**
**3001 Leuven (BE)**

(72) Inventor: **Vandervorst, Wilfried**
**2800 Mechelen (BE)**

(74) Representative: **Wauters, Davy Erik Angelo et al**
**DenK iP BVBA**
**Pastoor Ceulemansstraat 3**
**3191 Schiplaken (Hever) (BE)**

(54) **Laser atom probe and laser atom probe analysis methods**

(57)　The invention is related to a laser atom probe system comprising a specimen holder (7) whereon a specimen (2) to be analyzed may be mounted, the specimen having a tip shape, a detector (3), an electrode (1), arranged between the specimen holder (7) and the detector (3), a voltage source (4) configured to apply a voltage difference between the specimen tip and the electrode, at least one laser system (5,8), configured to direct a laser beam laterally at the specimen tip, and a tip shape monitoring means (10) configured to detect and monitor the tip shape, and/or a means for altering and/or controlling one or more laser parameters of said laser beam(s) so as to maintain, restore or control said specimen tip shape.

FIG. 4a

EP 2 434 521 A2

## Description

## Field of the invention

The present invention is related to atom probe tomography, in particular to a laser atom probe system and to laser atom probe analysis methods.

## Background of the invention

The scaling of semiconductor devices and the trend toward three-dimensional (3D) transistors require metrology methods allowing the characterization of interfaces and nanometer-sized structures with sub-nanometer depth and spatial resolution. The laser assisted atom probe has been proposed as a metrology tool for next generation and has evolved as a potential solution.

Atom probe tomography is based on field induced evaporation, a process which would be totally insensitive to any layer intermixing. Therefore the atom probe has been proclaimed to be the ideal depth profiling tool with a theoretical depth resolution approaching the lattice distances in a crystal. Also the field induced evaporation process is described as 100% efficient implying that quantification should be accurate as well.

An overview on the current state of the art relating to atom probe tomography can be found in a tutorial review from Miller et al., Atom probe tomography, Materials characterization 60 (2009), p. 461-469. Atom Probe Tomography (APT) is also known as Probe Field Ion Microscopy (APFIM) or if a pulsed laser is used, one often refers to pulsed laser atom probe (PLAP). For example Imago's LEAP system or Cameca's 3D Laser Assisted Atom Probe (LA-WATAP) may be used for atom probe microscopy measurements.

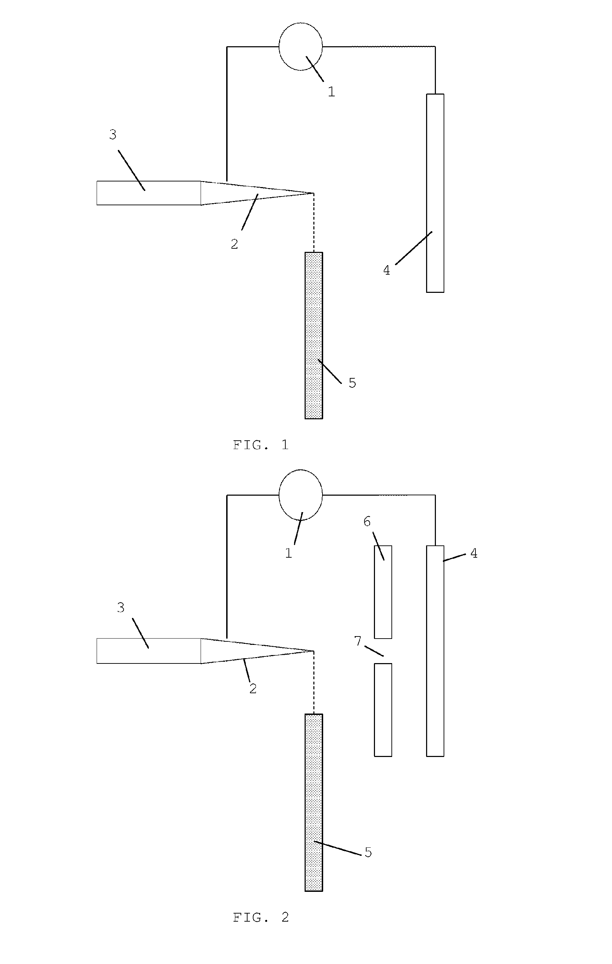

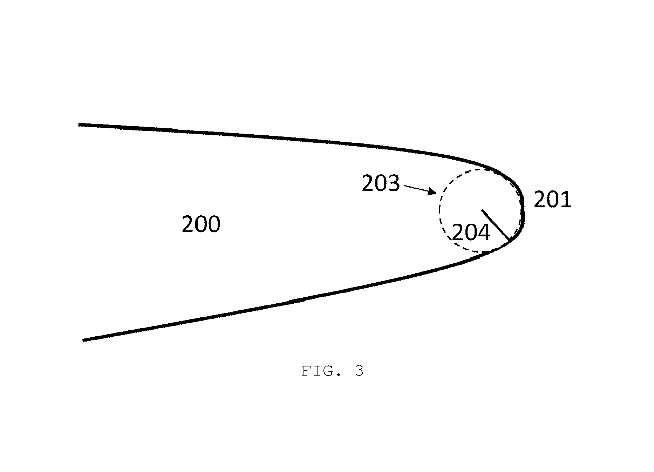

As shown schematically in figure 1, a laser atom probe system as presently known in the art comprises at least the following components : a DC voltage source 1 configured to be connected between a specimen 2 mounted in a specimen holder 3, and a detector 4. The specimen 2 is a small pointed probe comprising a tip end or tip apex 201 (figure 3) with an initial radius of curvature $R_{init}$ 204 in the range of 50-100nm. The radius of curvature is defined by the radius of the circle 203 which fits in the curvature of the tip end. The smaller the curvature of the tip end, i.e. the sharper the tip end, the smaller the radius of curvature R. The larger the curvature, i.e. the blunter the tip end, the larger the radius of curvature R. A laser system 5 is installed so as to produce one or more laser beams onto the probe tip. The preferred position of the laser system is such as to produce the beam laterally at the specimen tip. The term 'laser system' is to be understood as an apparatus comprising means for producing and a means for controlling a laser beam, i.e. adapting laser beam parameters such as wavelength and polarisation and power. Ions evaporated from the tip are projected onto the detector *means 3*, and analysed by an algorithm which determines the composition on the basis of the time of flight of the evaporated ions and the impact position. As shown in figure 2, a possible additional component is an electrode 6 placed between the specimen and the detector, with a hole 7 provided in the electrode. The electrode 6 may be connected to the same or a different voltage source 1 than the detector 4. The electrode's 6 function is to create only locally the required electrical field for evaporation and thus to provide an area selection for the analysis action.

To achieve the small tip probe of the specimen, focused ion beam (FIB) techniques may be used. Also chemical etching may be used to prepare the specimen, especially for metallic specimens. Thus depending on the material of the specimen, a different specimen preparation technique may be used.

During the AP analysis a high DC voltage or preferably a series of high DC voltage pulses (typically between 2 and 20kV) is applied to the tip of the specimen, i.e. between the electrode and the specimen. This results in a very strong electric field (several 10V/nm) near the apex of the specimen probe allowing ions to escape from the tip surface. This electric field is given by the formula :

$$ F = \frac{V}{\beta R} \; , $$

wherein
F is the electric field (V/nm), V is the voltage applied to the probe specimen (V), R is the radius of curvature of the tip apex of the probe specimen (nm) and $\beta$ is a geometric shape factor of the probe specimen. By consequence, the smaller the radius of curvature of the tip apex, i.e. the sharper the tip end, and the higher the voltage applied, the higher the electric field which may be achieved.

In this way, for highly conductive specimen materials, such as metals, electric fields can be reached which are powerful enough to cause the release of ions from the tip surface. However for semiconductor materials such as silicon, this is not the case due to the lower conductivity of the specimen material. This is why a laser system is added to the atom probe system. The laser system produces a laser beam or a bundle of several laser beams directed at the specimen tip, for example a bundle of beams at different wavelengths. The incident beam or beams cause a pulsed increase in the electric field sufficient to release ions from a semiconductor probe tip.

A problem with current laser APT systems is described hereafter. As laser atom probe tomography has a destructive nature due to the evaporation process of material of the specimen, more specifically of material at the tip end of the specimen, the initial radius of curva-

ture $R_{init}$ of the small pointed probe will modify during the atom probe tomography measurement. More precisely, while the tip has a spherical shape at the start of the analysis, the shape may become different from a spherical shape as the analysis progresses. For example, when the laser is applied to one side, as shown in figure 1 and 2, evaporation of the tip material is higher on this side, and the tip shape becomes flatter on this side while it remains round on the opposite side. As the actual specimen analysis algorithms performed via the detector are based on the assumption that the tip is spherical, the deformation of the tip leads to errors in the analysis.

**Summary of the invention**

It is an object of the present invention to provide good laser atom probe systems and methods for analysing a specimen by laser atom probe tomography.

According to a first inventive aspect a laser atom probe system is disclosed. The laser atom probe system comprises a specimen holder whereon a specimen to be analyzed may be mounted, the specimen having a tip shape, an detector, optionally an electrode, arranged between the specimen holder and the detector, a DC voltage source configured to apply a voltage difference between the specimen tip and the detector, a laser system, configured to direct one or more laser beams at the specimen tip, a tip shape monitoring means configured to detect and measure the specimen tip shape.

The specimen tip shape is preferably a spherical tip shape. The laser atom probe system may further comprise a means for controlling one or more laser parameters of said laser beam(s) so as to maintain the specimen tip shape, said means for controlling being configured to control the beam parameter(s) on the basis of the detected tip shape.

The monitoring means is preferably chosen from the group consisting of a scanning electron microscope (SEM), a transmission electron microscope (TEM), a scanning probe microscope (SPM). According to embodiments, in case of a monitoring means being a scanning probe microscopy (SPM) system, the SPM system is mounted to be moveable so that the SPM system can be moved into and out of a measurement position. The SPM system may be mounted on a moveable arm. The specimen tip may also be moved in and/or out towards the SPM tip.

According to embodiments the laser atom probe system further comprises one or more laser systems with a control loop arranged between the tip shape monitoring means and at least one of said laser systems.

Two of the one or more laser systems may be diametrically opposed on either side of the specimen tip.

According to embodiments, the laser atom probe system may further comprise at least one mirror configured to reflect laser beams produced by said laser system(s). A control loop may be arranged between said tip shape monitoring means and said mirror(s).

According to a second inventive aspect a laser atom probe system is disclosed. The laser atom probe system comprises a specimen holder whereon a specimen to be analyzed may be mounted, the specimen having a tip shape, a detector, optionally an electrode, arranged between the specimen holder and the detector, a DC voltage source configured to apply a voltage difference between the specimen tip and the detector, one laser system, configured to direct one or more laser beams at the specimen tip, a means for altering and/or controlling one or more laser parameters of said laser beam(s) so as to maintain, restore or control the specimen tip shape. Such maintaining, restoring or controlling the specimen tip shape may be maintaining, restoring or controlling as function of a measured or monitored tip shape or may be maintaining, restoring or controlling as function of a simulated result, calculated result or based on a predetermined algorithm or look-up-table.

The specimen tip shape may be a spherical tip shape.

The laser atom probe system may comprise a tip shape monitoring means configured to detect and measure the specimen tip shape.

The system may comprise a control loop arranged between the tip shape monitoring means and the means for altering and/or controlling one or more laser parameters of said laser beam(s) so as to maintain, restore or control the specimen tip shape.

The monitoring means may be chosen from the group consisting of a scanning electron microscope (SEM), a transmission electron microscope (TEM), an scanning probe microscope (SPM). The tip shape monitoring means may be an SPM system, and wherein said SPM system is mounted to be moveable so that the SPM system can be moved into and out of a measurement position. Alternatively, also the specimen holder may be moveable so as to move the specimen tip outside the ATP measurement position, towards a measurement position for the monitoring means.

According to embodiments, said means for altering and/or controlling comprises at least one additional laser system arranged so that the combined action of all laser systems maintains the tip shape.

According to embodiments two laser systems may be diametrically opposed on either side of the specimen tip.

According to embodiments said means for altering and/or controlling comprises at least one mirror configured to reflect laser beam(s) produced by said laser system(s) back towards the specimen tip, so as to maintain the tip shape.

According to embodiments the at least one laser beam parameter is chosen from the group consisting of wavelength, polarisation, beam power, number of beams having the same direction with respect to the specimen tip, number of beams having different directions with respect to the specimen tip, angle of incidence of the beam with respect to the specimen tip, (if applicable) position of the mirror.

According to a third inventive aspect a method for analysing a specimen by laser atom probe tomography is disclosed, the method comprising the steps of mounting a specimen in a holder, the specimen having a specimen tip shape, preferably a spherical tip shape, applying a DC voltage difference between the specimen tip and a detector, directing a series of laser beam pulses at the specimen tip, to thereby evaporate ions from the specimen tip, and direct said ions towards the detector, analysing the ions detected by the detector, interrupting said series of laser pulses at various times during an interruption time interval, during said time interval, detecting and measuring the shape of the specimen tip, after said time interval, resuming said series of laser beam pulses.

According to embodiments the method further comprises a step of adjusting one or more parameters of said laser beam pulses after each step of detecting and measuring the specimen tip shape, said adjustment being based on the detected shape of the specimen tip, in order to maintain the tip shape, and wherein after said time interval the series of beam pulses is resumed with the adjusted parameters applied to the laser beam pulses.

According to a fourth inventive aspect a method for analysing a specimen by laser atom probe tomography is disclosed, the method comprising the steps of mounting a specimen in a holder, the specimen having a tip shape, preferably a spherical tip shape, applying a DC voltage difference between the specimen tip and a detector, directing a first series of laser beam pulses at the specimen tip, to thereby evaporate ions from the specimen tip, and direct said ions towards the detector, analysing the ions detected by the detector, altering and/or controlling one or more parameters of said first series of beam pulses, so as to maintain, restore or control the tip shape.

The method also may comprise interrupting said series of laser pulses at various times during an interruption time interval, and during said time interval, detecting and measuring the shape of the specimen tip, wherein said altering and/or controlling comprises altering and/or controlling being based on the detected tip shape. According to embodiments, the step of altering and/or controlling comprises directing at least one further series of laser beam pulses at the specimen tip from a direction different from the direction of the first series of beam pulses.

According to embodiments, the parameters of the laser pulses may be chosen from the group consisting of wavelength, polarisation, beam power, number of beams having the same direction with respect to the specimen tip, number of beams having different directions with respect to the specimen tip, angle of incidence of the beam with respect to the specimen tip, position of a mirror positioned so as to reflect beam pulses back towards the specimen tip.

It is an advantage of certain inventive aspects that the specimen tip shape may be monitored in-situ of a laser atom probe system and during a laser atom probe measurement.

It is an advantage of certain inventive aspects that the specimen tip shape may be controlled in-situ of a laser atom probe system and during a laser atom probe measurement.

It is an advantage of certain inventive aspects that a spherical specimen tip shape may be maintained during a laser atom probe measurement.

It is an advantage of certain inventive aspects that reliable quantitative material analysis of a specimen is possible by using specimen laser atom probe analysis algorithms which rely on a spherical tip shape.

## Brief description of the figures

Figures 1 and 2 are schematic views of a laser atom probe system as known in the prior art.
Figure 3 illustrates the definition of the radius of curvature of the specimen tip.
Figures 4a to 4f show an atomic probe system according to various embodiments of the invention.

## Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention. Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description. In one aspect, the invention is related to a laser atom probe system comprising the elements as shown in figure 1 or 2, and further provided with a tip shape monitoring means configured to detect and measure the shape of the specimen tip and/or a means for altering and/or controlling one or more laser parameters so as to maintain said specimen tip shape. Preferably, the specimen tip shape is initially a spherical tip shape, and is maintained as a spherical tip shape and the invention will be described mainly on the basis of this preferred embodiment. However, any tip shape may be maintained and/or controlled in a system or with the method of the invention.

A preferred embodiment comprises both a monitoring means and a means for controlling one or more laser parameters, wherein said parameters are controlled on the basis of the detected tip shape, in order to maintain a spherical tip shape. 'Altering one or more laser parameters' includes altering parameters of one or more single laser beams produced by a laser system 5, such as the wavelength or polarisation or power, but also includes adding one or more additional laser beams directed to the tip, by increasing the number of beams produced by the laser system 5 or by providing and activating an additional laser system configured to produce beams at another angle to the tip, or by providing or moving a mirror configured to reflect laser beams back towards the specimen tip.

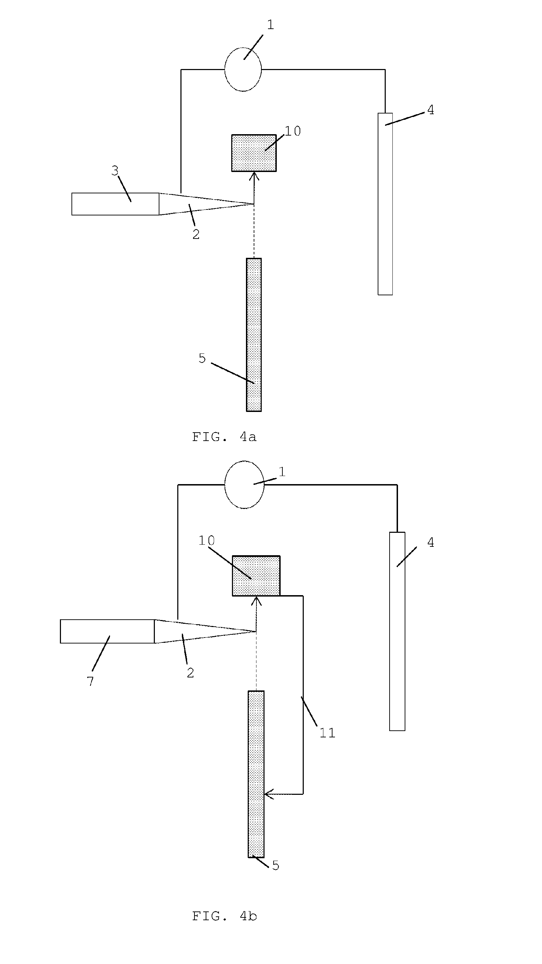

Figure 4a shows a first embodiment wherein one laser system 5 is provided to one side of the specimen tip as in the prior art systems, and wherein a tip shape monitoring means 10 is provided. The apparatus is primarily of use for the analysis of semiconductor specimens. The tip shape monitoring means 10 can be either one of the following systems: a scanning electron microscope (SEM), a transmission electron microscope (TEM), a scanning probe microscope (SPM). In the case of a TEM or SEM, the arrangement of the tip shape monitoring means with respect to the specimen tip can be done according to known methods, and is therefore within the knowledge of the skilled person. An SPM system included in the ATP system of the invention may be configured to utilise the known method used in the production of SPM probe tips, wherein a tip shape is detected by scanning it over a dedicated topography. In the present case, an SPM probe with a known shape may be scanned over the specimen tip, in order to detect the specimen tip shape. According to a preferred embodiment, an SPM probe is mounted on a movable arm configured to move the SPM probe into and out of a measurement position wherein the probe tip and the specimen tip are facing each other while being essentially oriented along their longitudinal axes. In this way, the SPM probe may be moved away from the specimen when a laser pulse is given and moved into the measurement position when no laser pulse is given, these movements being repeated at intermittent times, in order to measure and thus monitor the specimen tip shape. Alternatively, also the specimen tip may be moveably mounted in order to measure the tip in a measurement system positioned at the periphery of the ATP setup.

Figure 4b schematically shows the elements of an atomic probe system according to another embodiment of the invention. The system comprises both the probe tip shape monitoring means 10 and a means for controlling one or more parameters of the laser beam or beams produced by the laser system 5, in order to maintain a spherical specimen tip. The means for controlling laser beam parameters is symbolized by the feedback control loop 11 arranged between the monitoring system 10 and the control portion of the laser system 5. The control algorithm for maintaining a spherical shape can be configured for controlling one or more parameters of each laser beam produced by the laser system 5. These parameters can be: the wavelength of the laser beam, the polarisation of the beam, the power of the beam, the number of beams produced by the laser system, the angle of the incident laser beam with respect to the specimen tip, or other parameters. For example, when it is detected that the tip becomes flat, the beam's frequency may be changed from the ultraviolet range to the green or Infra Red frequency range, because at these wavelengths the absorption depth of the laser beam is increased.

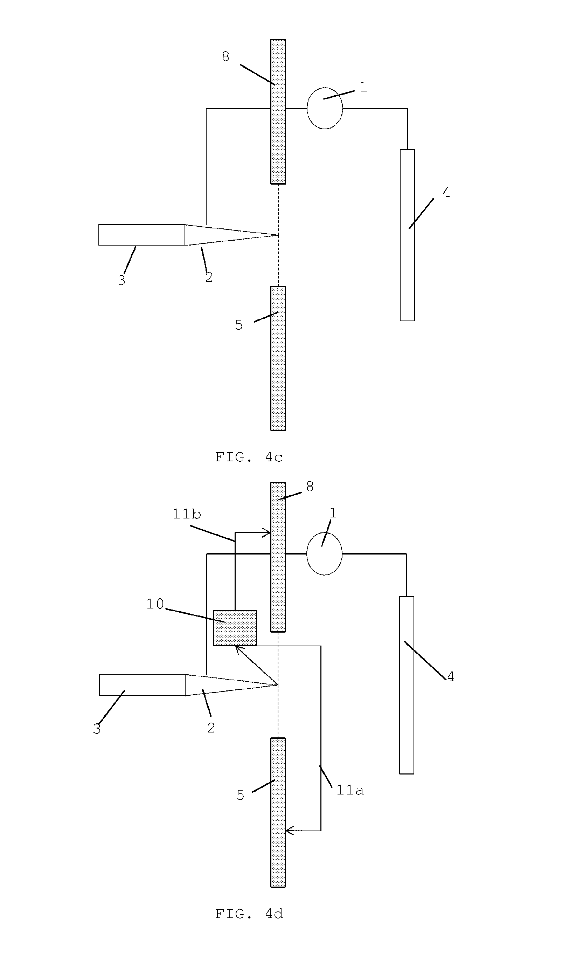

Figure 4c shows another embodiment, wherein a second laser system 8 is provided opposite the first laser system 5. The second laser beam is configured to provide one or more laser beams concurrently with the first system 5, so as to maintain a spherical specimen tip shape. The beam or beams produced by the second laser system 8 may have different parameters (e.g. wavelength) than the beam(s) produced by the first laser system 5.

Figure 4d shows an embodiment comprising two laser systems 5 and 8, and a tip shape monitoring means 10. The means for controlling the laser parameters preferably comprises two control loops 11a and 11b, though it is also possible to provide only one control loop to one of the laser systems. The control algorithm in this case may be configured for controlling the parameters as named above of both laser systems. According to a specific use of the system of figure 4d, the first laser 5 is used, and when deterioration of the tip is detected at the side of the first laser, the second laser 8 is activated. According to other embodiments, the two laser systems are not placed diametrically with respect to each other, or more than two laser systems may be provided around the tip.

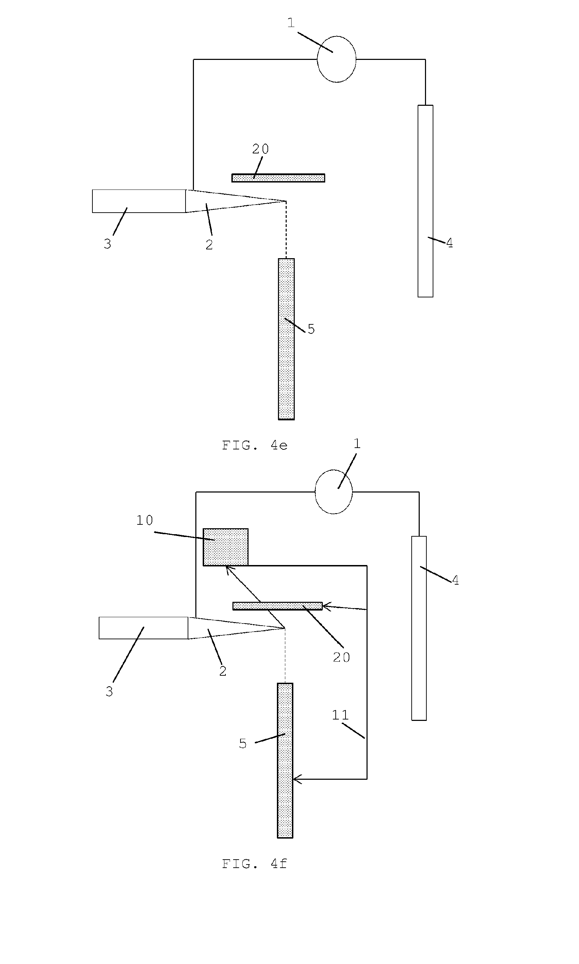

Figure 4e shows another embodiment, wherein a mirror 20 is provided opposite the laser system 5. The mirror reflects the laser beam, so that reflected laser light impinges on the opposite side of the specimen tip. In this way, flattening of the tip at the side where the laser is installed, is counteracted.

Figure 4f shows an embodiment equipped with a mirror 20 and with a tip shape monitoring means 10. The control loop 11 is shown to provide a feedback control towards the laser system 5 and towards the mirror 20. For example the mirror position may be adjusted as a function of the detected specimen tip shape, in order to maintain a spherical tip shape. Alternatively, the control loop may be provided only towards the laser system 5 or only towards the mirror 20. The invention includes embodiments with or without a tip shape monitoring means, and wherein one or more mirrors are mounted opposite one or more laser systems.

The invention is equally related to measurement and analysis methods applicable with a laser atom probe system of the invention. According to a first embodiment, the method of the invention comprises the steps of :

- Mounting a specimen 2 in a holder 3, the specimen having a (preferably spherical) tip shape,
- Applying a DC voltage difference between the specimen tip and a detector,
- Directing a series of laser beam pulses at the specimen tip, to thereby evaporate ions from the specimen tip, and direct said atoms towards the detector,
- Analysing the ions detected by the detector,
- Interrupting said series of laser pulses at various times during an interruption time interval,
- During said time interval, detecting and measuring the shape of the specimen tip,
- After said time interval, resuming said series of laser beam pulses.

In all embodiments of the method, the DC voltage is preferably applied in the form of a series of pulses on top of constant DC value. The laser beam pulses are then applied simultaneously with the DC pulses. According to a preferred embodiment, the method further comprises the step of adjusting one or more parameters of said laser beam pulses after each step of detecting and measuring the specimen tip shape, said adjustment being based on the detected shape of the specimen tip, in order to maintain a spherical tip shape, and wherein after said time interval the series of beam pulses is resumed with the adjusted parameters applied to the laser beam pulses.

The invention is further related to a method comprising the steps of :

- Mounting a specimen 2 in a holder 3, the specimen having a (preferably spherical) tip shape,
- Applying a DC voltage difference between the specimen tip and a detector,
- Directing a series of laser beam pulses at the specimen tip, to thereby evaporate ions from the specimen tip, and direct said ions towards the detector,

• Analysing the ions detected by the detector
• Altering and/or controlling one or more parameters of said series of beam pulses, so as to maintain a spherical tip shape

According to an embodiment, the step of altering and/or controlling comprises directing at least one further series of laser beam pulses at the specimen tip from a direction different from the direction of the series of beam pulses. In the above described embodiments of the method of the invention, said parameters may be chosen from the group consisting of

• wavelength
• Polarisation
• Beam power
• Number of beams having the same direction with respect to the specimen tip
• Number of beams having different directions with respect to the specimen tip
• Angle of incidence of the beam with respect to the specimen tip
• Position of a mirror positioned so as to reflect beam pulses back towards the specimen tip

Figures 4a to 4f illustrate embodiments of the method as well as of the system of the invention. All details described in the detailed description of the system of the invention are applicable to the method of the invention.

The invention and different embodiments of the method as well as of the system of the invention as described herein refer to a specimen tip shape, more specifically to a spherical specimen tip shape and maintaining and/or controlling the spherical specimen tip shape during the laser atom probe measurement. However it is clear for a person skilled in the art that any specimen tip shape may be used. It is an advantage of embodiments of the method as well as of the system of the invention that the specimen tip shape may be maintained and/or controlled, the specimen tip shape being spherical or any other kind of shape suitable for the laser atom probe technique.

**Claims**

1. A laser atom probe system comprising :

   - a specimen holder (3) configured for mounting a specimen (2) to be analyzed having a tip shape,
   - a detector (4),
   - a DC voltage source (1) configured to apply a voltage difference between the specimen tip and the detector,
   - a laser system (5), configured to direct one or more laser beams at the specimen tip,- a means for altering and/or controlling one or more laser parameters of said laser beam(s) so as to maintain, restore or control the specimen tip shape.

2. A laser atom probe system according to claim 1, wherein said means for altering and/or controlling comprises at least one additional laser system (8) arranged so that the combined action of all laser systems maintains, restores or controls the tip shape.

3. A laser atom probe system according to any of the previous claims, the laser atom probe system comprising two laser systems (5,8) diametrically opposed on either side of the specimen tip.

4. A laser atom probe system according to any of the previous claims, wherein said means for altering and/or controlling comprises at least one mirror (20) configured to reflect laser beam(s) produced by said laser system(s) towards the specimen tip for maintaining, restoring or controlling the tip shape.

5. A laser atom probe system according to any of the previous claims, wherein said at least one laser beam parameter is chosen from the group consisting of wavelength, polarisation, beam power, number of beams having the same direction with respect to the specimen tip, number of beams having different directions with respect to the specimen tip, angle of incidence of the beam with respect to the specimen tip, position of a mirror (20).

6. A laser atom probe system according to any of the previous claims, wherein said specimen tip shape is a spherical tip shape.

7. A laser atom probe system according to any of the previous claims, the laser atom probe system comprising a tip shape monitoring means (10) configured to detect and measure the specimen tip shape.

8. A laser atom probe system according to claim 7, comprising a control loop (11,11a,11b) arranged between said tip shape monitoring means and the means for altering and/or controlling one or more laser parameters of said laser beam(s) so as to maintain, restore or control the specimen tip shape.

9. A laser atom probe system according to any of claims 7 or 8, wherein the monitoring means is chosen from the group consisting of a scanning electron microscope (SEM), a transmission electron microscope (TEM), an scanning probe microscope (SPM).

10. A laser atom probe system according to any of claims 7 to 9 , wherein the tip shape monitoring means is an SPM system, and wherein said SPM system is mounted to be moveable so that the SPM system can be moved into and out of a measurement position.

11. A method for analysing a specimen by laser atom probe tomography, comprising the steps of

- mounting a specimen (2) in a holder (3), the specimen having a tip shape,
- applying a DC voltage difference between the specimen tip and a detector (4),
- directing a series of laser beam pulses at the specimen tip, to thereby evaporate ions from the specimen tip, and direct said atoms towards the detector,
- analysing the ions detected by the detector, and
- altering and/or controlling one or more parameters of said series of beam pulses, so as to maintain, restore or control the tip shape.

12. A method according to claim 11, wherein the step of altering and/or controlling comprises directing at least one further series of laser beam pulses at the specimen tip from a direction different from the direction of the series of beam pulses.

13. A method according to any of claims 11 or 12, wherein said parameters are chosen from the group consisting of wavelength, polarisation, beam power, number of beams having the same direction with respect to the specimen tip, number of beams having different directions with respect to the specimen tip, angle of incidence of the beam with respect to the specimen tip, position of a mirror positioned so as to reflect beam pulses back towards the specimen tip.

14. Method according to any of the preceding embodiments, wherein said specimen tip shape is spherical tip shape.

15. A method according to any of claims 11 to 14, the method comprising

- interrupting said series of laser pulses at various times during an interruption time interval, and during said time interval, detecting and measuring the shape of the specimen tip, wherein said altering and/or controlling comprises altering and/or controlling being based on the detected tip shape.

FIG. 1

FIG. 2

FIG. 3

FIG. 4a

FIG. 4b

FIG. 4c

FIG. 4d

FIG. 4e

FIG. 4f

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MILLER et al.** Atom probe tomography. *Materials characterization,* 2009, vol. 60, 461-469